Europäisches Patentamt

European Patent Office

Office européen des brevets

(11) Numéro de publication: **0 498 329 A1**

## DEMANDE DE BREVET EUROPEEN

(21) Numéro de dépôt: **92101699.4**

(22) Date de dépôt: **03.02.92**

(51) Int. Cl.⁵: **H01L 25/07**

(30) Priorité: **06.02.91 FR 9101316**

(43) Date de publication de la demande:
**12.08.92 Bulletin 92/33**

(84) Etats contractants désignés:
**CH DE FR LI**

(71) Demandeur: **ALCATEL CABLE**
**30, rue des Chasses**
**F-92111 Clichy Cédex(FR)**

(72) Inventeur: **Hourtane, Jean-Luc**
**1 Placette de Picardie**
**F-95740 Frepillon(FR)**
Inventeur: **Leconte, Eric**
**19 rue Médéric**
**F-92110 Clichy(FR)**

(74) Mandataire: **Weinmiller, Jürgen et al**
**Lennéstrasse 9 Postfach 24**
**W-8133 Feldafing(DE)**

(54) **Diode haute tension de verrouillage d'onde.**

(57) La diode haute tension de verrouillage d'onde est caractérisée en ce qu'elle est constituée par un empilage alterné de pastilles semiconductrices (11) et de rondelles conductrices (12), centrées les unes sur les autres à l'aide de bagues isolantes de centrage (14) rapportées sur les pastilles individuelles et pressées les unes contre les autres entre des semelles conductrices (17, 18) d'un boîtier étanche pressurisé (15), à paroi isolante tubulaire (16), dans lequel est monté ledit empilage.
Application : circuit de décharge d'impulsion de forte énergie dans un élément à tester.

FIG.2

EP 0 498 329 A1

La présente invention porte sur une diode haute tension, utilisée en particulier dans un générateur d'impulsion de courant de très forte énergie déchargée dans un élément à tester, dite diode de verrouillage d'onde.

Une telle diode doit supporter des tensions très élevées, pouvant être de l'ordre du mégavolt, et de très fortes intensités de courant, de 10 à 200 kA.

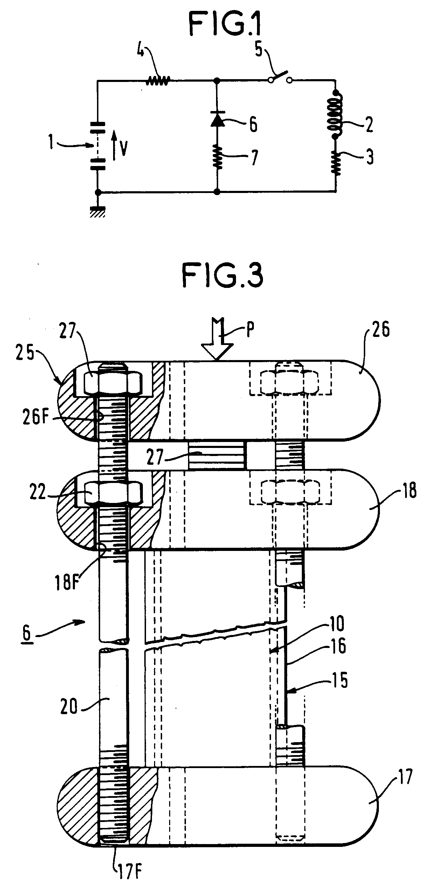

La figure 1 du dessin ci-annexé donne le schéma d'un circuit en tant que tel connu illustrant l'application ci-avant d'une telle diode. Dans ce circuit, un générateur très haute tension 1 est constitué par une batterie de condensateurs chargée par une alimentation continue haute tension, non représentée. Il se décharge dans une inductance 2 et une résistance 3 en série, qui lui sont reliées à travers une résistance d'amortissement 4 et un interrupteur 5, lorsque cet interrupteur est fermé. Une diode 6 haute tension de verrouillage d'onde et une résistance de verrouillage 7 en série avec cette diode sont montées en parallèle sur l'inductance 2 et la résistance de charge 3.

Dans ce circuit, l'inductance 2 relativement faible, représente l'inductance d'un élément à tester et celle des câbles assurant sa connexion au circuit. La résistance de charge 3 représente la résistance de l'élément à tester et celle des câbles de connexion.

La diode 6, polarisée en inverse, reste bloquée lors de la fermeture de l'interrupteur 5. Elle devient par contre passante à la fin de la décharge de la batterie de condensateurs 1 dans l'inductance 2 dont le courant est alors maximal. Dans ces conditions, elle permet à l'inductance de se décharger à travers elle et les résistances 3 et 7, selon le principe appelé de verrouillage d'onde.

Cette diode de verrouillage d'onde, devant tenir aux valeurs importantes de tension alors qu'elle est bloquée et de courant de décharge de l'inductance quand elle est passante, est réalisée de manière habituelle par au moins un empilement de diodes individuelles commercialisées sous le nom "Press-Pack". Ces diodes "Press-Pack" sont empilées en série et très fortement pressées les unes contre les autres. Les empilements sont montés en parallèle. La longueur des empilements conduit un encombrement impressionnant et, en outre, à une inductance parasite importante.

La présente invention a pour but de réaliser une diode de verrouillage d'onde minimisant les inconvénients précités, en particulier permettant de réduire l'encombrement et l'inductance parasite qu'elle présente, chacun dans un rapport de l'ordre de 4.

Elle porte sur une diode haute tension de verrouillage d'onde, caractérisée en ce qu'elle est constituée par un empilage alterné de pastilles semi-conductrices et de rondelles conductrices, centrées les unes sur les autres et pressées fortement les unes contre les autres dans un boîtier, avec lesdites pastilles dudit empilage formées par des pastilles semiconductrices de diodes de type "Press-Pack", munies individuellement d'une première bague isolante périphérique saillante sur la périphérie d'une première de leurs faces, et équipées individuellement, en outre, d'une deuxième bague périphérique en matériau de faible coefficient de frottement saillante sur la périphérie de la deuxième face de chacune d'elles et dite bague de centrage, et avec ledit boîtier comportant une paroi tubulaire isolante autour dudit empilage et deux semelles conductrices de contact, fermant la paroi tubulaire et appliquées en pression sur les deux éléments terminaux dudit empilage.

La diode selon l'invention présente en outre l'une ou l'autre des particularités suivantes :
- ledit boîtier est préssurisé et étanche,
- les semelles de contact dudit boîtier présentent une entrée et sortie d'air sous pression, débouchant dans le boîtier au fond d'une échancrure de leur face interne.
- lesdites semelles de contact sont maintenues serrées sur l'empilage par des tirants isolants bloqués dans lesdites semelles de contact et éventuellement dans une semelle de pression couplée élastiquement à l'une des semelles de contact.
- l'empilage a l'un de ses éléments terminaux formé par une rondelle conductrice dite câle d'épaisseur rendant sa hauteur constante d'une diode à une autre diode.

Les caractéristiques et avantages de la présente invention ressortiront de la description donnée ci-après d'un exemple de réalisation illustré dans les dessins ci-annexés.

Dans ces dessins :
- la figure 1 est un schéma de circuit connu d'un générateur impulsionnel de courant à haute énergie de test, dans lequel est utilisée une diode haute tension de verrouillage d'onde selon l'invention,
- la figure 2 représente la diode haute tension de verrouillage d'onde selon l'invention,
- la figure 3 représente un montage complet de cette diode.

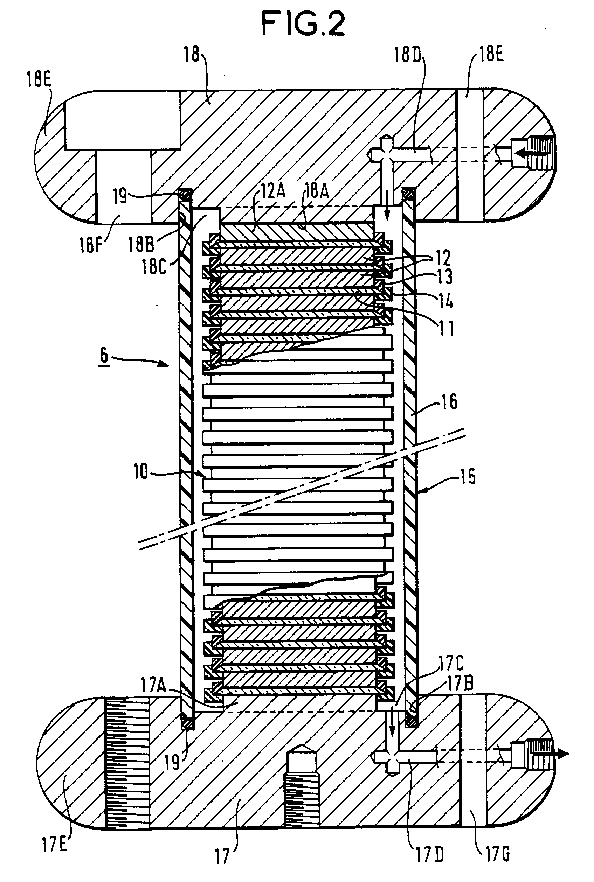

La figure 2 montre que la diode haute tension de verrouillage d'onde 6, selon l'invention, est constituée par un empilage 10 de pastilles semi-conductrices 11 et de rondelles conductrices 12, alternées et fortement pressées les unes contre les autres. Les deux éléments terminaux de l'empilage peuvent être deux pastilles semiconductrices ou, comme illustré dans cette figure 2, une pastille semiconductrice et une rondelle conductrice, cette dernière notée 12A étant en outre de préférence d'épaisseur adéquate pouvant être différente de celles des autres rondelles et jouant alors le rôle de câle, pour l'obtention d'une même hauteur d'un empilement à un autre alors que leurs éléments sont pressés.

Les pastilles semiconductrices 11 sont les parties actives des diodes "Press-Pack" précitées. Elles sont équipées initialement d'une bague périphérique individuelle 13, en caoutchouc, qui est saillante sur l'une de leurs faces. Les rondelles conductrices 12 sont sensiblement de même diamètre que ces pastilles 11. Elles sont en matériau très bon conducteur électrique. Elles sont réalisées massives en molybdène ou en cuivre ou peuvent être en cuivre et avoir leurs deux faces recouvertes d'un feuillard de molybdène.

Les pastilles semiconductrices 11, équipées de leur bague en caoutchouc 13, et les rondelles conductrices 12 sont centrées les unes sur les autres à l'aide de bagues isolantes de centrage 14. Elles sont en matériau isolant de faible coefficient de frottement, en particulier tel que celui connu sous la marque "Téflon". Elles sont de section épaulée. Chacune d'elles vient en appui sur la périphérie de la bague en caoutchouc 13 de chaque pastille semiconductrice, sur une partie de sa hauteur, et déborde légèrement sur la face de cette pastille, sur laquelle la bague en caoutchouc n'est pas saillante. Chaque rondelle conductrice 12, entre deux pastilles semiconductrices, se trouve ainsi encastrée entre ces deux pastilles, la bague en caoutchouc saillante sur l'une d'elles et la bague en Téflon rapportée sur l'autre, ces deux bagues 13 et 14 venant en appui l'une sur l'autre.

Cet empilage alterné de pastilles semiconductrices 11 et de rondelles conductrices 12 ainsi centrées les unes sur les autres est monté dans un boîtier étanche 15. Ce boîtier est constitué par un tube isolant 16, en plastique translucide, de diamètre légèrement supérieur à celui de l'empilage, qui est fermé à ses deux extrémités par deux semelles conductrices 17 et 18 pressées fermement contre les deux éléments terminaux de l'empilage et en bon contact électrique avec eux. Elles sont par exemple en aluminium.

Ces deux semelles 17 et 18 forment les deux bornes de la diode 6 de verrouillage d'onde. Elles ont l'une et l'autre une partie médiane cylindrique 17A, 18A de même diamètre sensiblement que les pastilles semiconductrices et les rondelles conductrices, de contact en pression contre les éléments terminaux. L'une d'elles a sa partie cylindrique 17A encastrée dans la bague de centrage en Téflon montée sur la pastille semiconductrice terminale, au bas de l'empilage. L'autre a sa partie cylindrique 18A directement en appui contre la rondelle conductrice ou cale terminale supérieure 12A.

Ces deux semelles présentent, dans leur face intérieure au boîtier 15, une rainure 17B, 18B, dans laquelle s'encastre le tube 16, et une échancrure circulaire 17C, 18C, intérieure et directement attenante à la rainure et plus large mais moins profonde que la rainure. Cette échancrure délimite la partie médiane 17A, 18A de contact.

Un joint torique d'étanchéité 19 est monté dans le fond de chaque rainure 17B, 18B et assure l'étanchéité du boîtier 15.

Ce boîtier 15 est de préférence pressurisé, pour l'obtention d'une tension de claquage élevée de la diode 6. L'empilage 10 de pastilles semiconductrices en série est par exemple soumis à une pression d'air de 3 bars, dans le boîtier 15.

Pour cette pressurisation, deux perçages ou piquages d'entrée et de sortie de gaz 17D, 18D sont prévus dans les deux semelles 17 et 18 respectivement. Ils débouchent latéralement où ils sont reliées à des conduites adéquates équipées de vannes, non représentées, et dans le boîtier 15, de préférence au fond des échancrures respectives 17C, 18C comme représenté.

Les deux semelles 17 et 18 sont saillantes sur la périphérie du tube 16, à ses extrémités. Leurs dimensions sont adaptées à l'application spécifique de la diode de verrouillage d'onde résultante 6. Leur bord périphérique 17E, 18E est arrondi pour éviter un effet corona.

Ces deux semelles 17 et 18 présentent en outre des jeux de trous 17F et 18F à travers toute leur épaisseur, sur la périphérie du tube 16 pour leur serrage sur l'empilage 10. Elles présentent un autre jeu de trous 17G, 18G pour la fixation de la diode sur un support, pour son montage dans le circuit selon la figure 1.

La figure 3 montre un exemple de réalisation d'un tel système de serrage. Dans cette figure, l'empilage 10 non représenté en détail est dans le boîtier étanche précité 15, formé par le tube 16 et les deux semelles 17 et 18 qui ferme le tube.

La système de serrage est constitué par un jeu de tirants isolants filetés 20 montés dans les paires de trous 17F et 18F des semelles. Ces tirants sont vissés dans les trous taraudés 17F de la semelle inférieure et bloqués à l'aide d'écrous 22 dans la semelle supérieure en assurant son serrage à forte pression sur l'empilage 10 et la semelle inférieure.

Ce serrage est en particulier obtenu par un ensemble de serrage 25, constitué par une semelle de pression 26 et une entretoise élastique 27 entre la semelle de pression et la semelle supérieure 18 du boîtier 15.

L'entretoise élastique est un jeu de rondelles élastiques de répartition uniforme d'un effort de compression P appliqué à la semelle de pression par un système extérieur non illustré, tel qu'un vérin. La semelle de pression soumise à cet effort reçoit les extrémités des tirants isolants 20, enfilés et bloqués dans un jeu de trous 26F analogues à ceux des semelles 18, qu'elle présente, à l'aide d'écrous 27.

Ce système de serrage permet l'utilisation de tirants isolants supportant mal des efforts de torsion. Bien entendu lorsque les tirants utilisés peuvent supporter des efforts de torsion, le système de serrage à pression 25 n'est pas nécessaire, l'effort de pression pouvant être obtenu directement par serrage des écrous 22 sur les extrémités des tirants dans les trous 18F de la semelle supérieure de contact.

**Revendications**

1. Diode haute tension de verrouillage d'onde, caractérisée en ce qu'elle est constituée par un empilage alterné de pastilles semi-conductrices (11) et de rondelles conductrices (12), centrées les unes sur les autres et pressées fortement les unes contre les autres dans un boîtier (15), avec lesdites pastilles dudit empilage (10) formées par des pastilles semiconductrices de diodes de type "Press-Pack", munies individuellement d'une première bague isolante périphérique (13) saillante sur la périphérie d'une première de leurs faces, et équipées individuellement, en outre, d'une deuxième bague périphérique (14) en matériau de faible coefficient de frottement saillante sur la périphérie de la deuxième face de chacune d'elles et dite bague de centrage, et avec ledit boîtier (15) comportant une paroi tubulaire isolante (16) autour dudit empilage (10) et deux semelles conductrices (17, 18) de contact, fermant la paroi tubulaire et appliquées en pression sur les deux éléments terminaux dudit empilage (10).

2. Diode selon la revendication 1, caractérisée en ce que ledit boîtier (15) est pressurisé et rendu étanche à l'aide d'un joint torique (19) à chacune des jonctions entre ladite paroi tubulaire (16) et les semelles de contact (17, 18).

3. Diode selon la revendication 2, caractérisée en ce que lesdites semelles de contact, présentent chacune une rainure circulaire (17B, 18B), de diamètre sensiblement égal à celui de la paroi tubulaire, dans laquelle est logé ledit joint torique (19).

4. Diode selon la revendication 3, caractérisée en ce que lesdites semelles de contact (17, 18) sont traversées par une entrée et une sortie (17D, 18D) d'air sous pression dans ledit boîtier.

5. Diode selon la revendication 4, caractérisée en ce que chacune desdites semelles de contact (17, 18) présente une échancrure circulaire (17C, 18C), intérieure mais moins profonde que ladite rainure dans laquelle elle est ouverte sur sa périphérie, délimitant sur la semelle une partie médiane (17A, 18B) sensiblement de même diamètre que celui desdites rondelles et desdites pastilles et présentant l'une desdites entrée et sortie d'air débouchant dans son fond.

6. Diode selon l'une des revendications 1 à 5, caractérisée en ce que lesdites semelles de contact (17, 18) sont saillantes sur la périphérie de la paroi tubulaire (16) et sont à bords arrondis (17E, 18E).

7. Diode selon la revendication 6, caractérisée en ce qu'elle comporte un jeu de tirants isolants (20) extérieurs à ladite paroi tubulaire (16), de serrage desdites semelles de contact sur l'empilage (10).

8. Diode selon la revendication 7, caractérisée en ce qu'elle comporte un ensemble de serrage (25) comportant une semelle de pression (26) couplée à l'une des semelles de contact (17, 18) par une entretoise élastique (27) et soumise à une pression extérieure de serrage desdites semelles de contact pour le blocage lesdits tirants (20) dans ladite semelle de pression et lesdites semelles de contact.

9. Diode selon l'une des revendications 1 à 8, caractérisée en ce que chaque bague de centrage (14) est épaulée et réalisée en un matériau tel que celui connu sous la marque "Teflon".

10. Diode selon l'une des revendications 1 à 9, caractérisée en ce que l'un desdits éléments terminaux de l'empilage est une rondelle conductrice dite câle (12A), d'épaisseur choisie pour que la diode ait une hauteur donnée, restant sensiblement la même d'une diode à une autre.

## FIG.1

## FIG.3

# FIG.2

Office européen
des brevets

**RAPPORT DE RECHERCHE EUROPEENNE**

Numero de la demande

EP    92 10 1699

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | WO-A-8 601 035 (SUNSTRAND)<br>* revendication 1; figure 3 *<br>* page 8, alinéa 2 - page 12, alinéa 3 *<br>* page 13, alinéa 3 *<br>--- | 1,2,4,7 | H01L25/07 |
| A | EP-A-0 345 067 (WESTINGHOUSE)<br>--- | | |
| A | GB-A-823 350 (CO FREINS ET SIGNAUX WESTINGHOUSE)<br>--- | | |
| A | FR-A-2 277 433 (AUXILEC)<br>--- | | |
| A | FR-A-1 343 035 (SIEMENS)<br><br>----- | | |
| | | | **DOMAINES TECHNIQUES RECHERCHES (Int. Cl.5)**<br><br>H01L |

Le présent rapport a été établi pour toutes les revendications

| Lieu de la recherche | Date d'achèvement de la recherche | Examinateur |
|---|---|---|
| LA HAYE | 03 AVRIL 1992 | DE RAEVE R.A.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.12 (P0402)